# FASCICULE DE BREVET EUROPEEN

(11) **EP 1 938 362 B1**
(45) Date de publication et mention de la délivrance du brevet: **21.08.2013**
(21) Numéro de dépôt: 06808200.7
(22) Date de dépôt: 25.09.2006
(51) Int. Cl.: H01L 21/20

(54) **PROCEDE DE FABRICATION D'UN ELEMENT EN COUCHES MINCES**
VERFAHREN ZUM HERSTELLEN EINES DÜNNFILMELEMENTS
METHOD FOR MAKING A THIN-FILM ELEMENT

(30) Priorité: 28.09.2005 FR 0509897
(43) Date de publication de la demande: 02.07.2008
(73) Titulaire: Commissariat à l'Énergie Atomique et aux Énergies Alternatives, 75015 Paris (FR)
(72) Inventeur: DEGUET, Chrystel, F-38330 Saint Ismier (FR); CLAVELIER, Laurent, F-38000 Grenoble (FR)
(74) Mandataire: Colombo, Michel
(86) Numéro de dépôt international: PCT/FR2006/002184
(87) Numéro de publication internationale: WO 2007/036631

(56) Documents cités:
- US-A1- 2002 081 861
- US-A1- 2004 150 006
- US-A1- 2005 067 377

## Description

L'invention concerne un procédé de fabrication d'un élément en couches minces.

Dans de tels procédés, on utilise fréquemment un support comme structure donneuse : une partie de la structure donneuse (en général une couche superficielle) est utilisée comme élément de la structure cible, par exemple au moyen d'un report de couche.

On rencontre notamment cette solution pour la fabrication d'une structure de type germanium sur isolant (GeOI), comme cela est décrit par exemple dans les articles "Germanium-On-Insulator (GeOI) structure realized by the smart cut™ Technology", de F. Letertre et. al. in Mat. Res. Soc. Symp. Proc. Vol. 809, 2004 Materials Research Society et *"*200 mm Gemanium-On-Insulator (GeOI) Structures realized from epitaxial wafers using the smart cut™ technology", de C. Deguet et al., ECS 2005, Québec, vol. 2005 - 05, page 78.

Ces articles proposent deux solutions alternatives pour reporter la couche mince de germanium qui forme la couche superficielle de la structure GeOI : on utilise comme substrat donneur soit un substrat (ou wafer selon le terme anglais) de germanium massif (parfois dénommé "Ge *Bulk*"), soit un substrat en silicium sur lequel on a déposé par épitaxie une couche de germanium dont une partie au moins sera reportée.

La solution utilisant du germanium massif est avantageuse notamment sur le plan électrique du fait de la très bonne qualité cristalline du matériau reporté (taux de dislocations du germanium massif proche de zéro), mais la manipulation du germanium massif est relativement complexe, du fait notamment de la forte densité massique de ce matériau, ainsi que de sa fragilité mécanique

C'est pourquoi on envisage plutôt à l'heure actuelle d'utiliser en pratique comme substrat donneur la structure à base de germanium épitaxié sur un silicium déjà mentionnée.

La mise en oeuvre de cette solution proposée dans les articles déjà cités conduit toutefois à l'obtention de couches de germanium présentant un taux de dislocations de l'ordre de quelques 10⁶ cm⁻², générées essentiellement lors de la phase d'épitaxie du germanium sur le silicium du fait de la différence de paramètre de maille entre les réseaux cristalline de ces deux matériaux (Δ = 4,2 %).

De manière générale, il peut être intéressant d'utiliser ainsi comme substrat donneur une structure composée d'un premier matériau déposé par épitaxie sur un second matériau (par exemple pour profiter des propriétés électriques ou plus généralement des propriétés physiques, de l'un et des propriétés mécaniques de l'autre). Si ces deux matériaux ont des paramètres de mailles différents, ce type de solution conduit toutefois sans précaution particulière à un taux de dislocations relativement important dans la couche du premier matériau, ce qui peut diminuer les propriétés électriques et/ou physiques de cette couche.
De l'état de la technique est également connu de :
- US2004/0150006 A1,
- US2002/0081861 A1,
- US2005/0067377 A1.

Afin d'améliorer cet état de fait, et notamment de proposer un procédé de fabrication d'un élément en couche mince qui puisse allier une facilité de manipulation du substrat donneur et un faible taux de dislocations dans la couche donnée par celui-ci, l'invention propose un procédé de fabrication conforme à la revendication 1.

On obtient ainsi très peu de dislocations dans la couche du premier matériau. On peut de ce fait choisir indépendemment les deux matériaux pour leurs propriétés respectives, sans que ce choix ne se fasseau préjudice de la qualité cristalline de la couche épitaxiée.

Selon l'invention on effectue préalablement à la formation de la couche de diélectrique, une étape de croissance par épitaxie d'une couche de troisième matériau sur ladite couche du premier matériau, le matériau et l'épaisseur de la couche de troisième matériau étant choisis de sorte que le paramètre de maille du troisième matériau soit déterminé par celui de la couche cristalline du support.

La couche du premier matériau est ainsi encapsulée, et donc protégée, entre les couches des second et troisième matériaux. Par ailleurs, les couches sont de bonne qualité puisque le paramètre de maille est uniforme dans cette partie de la structure.

Le troisième matériau est du silicium.

On peut alors éventuellement procéder aux étapes suivantes postérieures à l'étape d'élimination du support :
- gravure locale de la couche cristalline du premier matériau jusqu'à la couche du troisième matériau ;
- croissance par épitaxie du troisième matériau sur les régions de la couche du troisième matériau mises à nu par la gravure.

On obtient ainsi en surface des régions du premier matériau et des régions du troisième matériau, toutes de bonne qualité cristalline. Chaque région peut ainsi être utilisée dans un but spécifique selon ses propriétés propres.

L'étape de formation de la couche de diélectrique peut comprendre une étape d'oxydation au moins partielle de la couche épitaxiée du troisième matériau afin d'obtenir ladite couche de diélectrique.

Cette solution est particulièrement pratique et génère une couche d'oxyde de qualité particulièrement bonne. Elle souligne par ailleurs l'intérêt de l'étape de croissance par épitaxie de la couche du troisième matériau mentionnée ci-dessus.

En variante, l'étape de formation de la couche de diélectrique de la structure comprend une étape de dépôt d'une couche de diélectrique.

La couche de diélectrique est par exemple une couche d'oxyde.

Selon un mode de réalisation, le support est une plaque du second matériau.

Selon un autre mode de réalisation, le support est du type couche superficielle sur isolant dont la couche superficielle forme la couche cristalline du second matériau.

Le premier matériau est du germanium. Ce cas particulier est intéressant du fait des propriétés physiques (notamment de transport électrique) du germanium et des difficultés à le manipuler.

Le second matériau est par exemple du silicium massif dont l'utilisation est relativement courante et la manipulation par conséquent possible avec des moyens classiques.

Selon une variante envisageable, le second matériau est du silicium contraint ou du SiGe, ce qui a notamment pour effet d'augmenter l'épaisseur critique de germanium.

Dans tous les cas, on peut envisager une étape de croissance par épitaxie du premier matériau sur la face de la couche cristalline du premier matériau laissée libre par l'élimination du support.

La couche de premier matériau finalement obtenue sera dans son ensemble de meilleure qualité qu'une couche de premier matériau de même épaisseur déposée directement sur le support en second matériau.

D'autres caractéristiques et avantages de l'invention apparaîtront à la lecture de la description qui suit, faite en référence aux dessins annexés dans lesquels :
- les figures 1 à 7 représentent les principales étapes d'un premier exemple de procédé de fabrication d'un élément en couches minces conforme aux enseignements de l'invention ;
- les figures 8 et 9 représentent deux étapes d'un procédé de fabrication d'un élément en couches minces selon un second exemple de mise en oeuvre de l'invention ;
- les figures 10 et 11 représentent deux étapes ultérieures applicables éventuellement aux structures obtenues par les procédés précités.

Les épaisseurs des couches représentées sur les figures sont seulement illustratives et ne doivent pas être comprises comme proportionnelles à l'épaisseur dés couches dans la réalité.

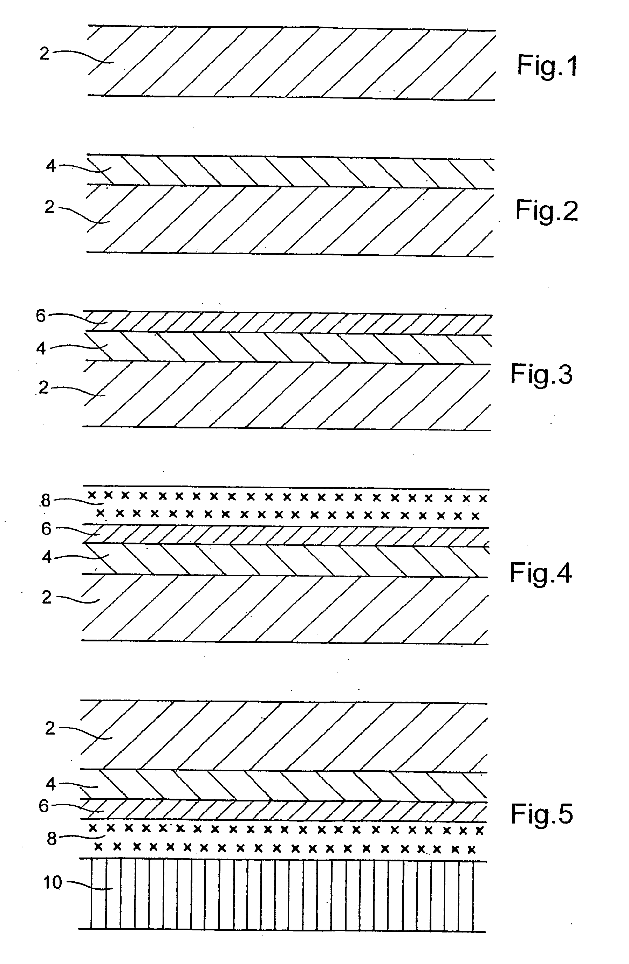

Un premier mode de réalisation de l'invention est à présent décrit en référence aux figures 1 à 7.

Dans ce mode de réalisation, on utilise une plaque 2 de silicium cristallin, comme schématiquement représenté en figure 1. Il s'agit donc ici de silicium parfaitement relaxé. En variante, il est possible d'utiliser un substrat présentant en surface une couche de silicium, par exemple un substrat SOI (silicium sur isolant). Une telle structure comprend un substrat massif (en général en silicium), une couche d'oxyde enterré (généralement dénommée BOX de l'anglais "*Buried Oxide*") et une couche superficielle de silicium. Dans une autre variante, on peut utiliser un substrat de silicium présentant une zone fragile enterrée obtenue par exemple par implantation d'espèces gazeuses (hydrogène par exemple) favorisant l'élimination ultérieure du substrat et sa réutilisation.

On fait croître par épitaxie sur cette plaque 2 de silicium une couche 4 de germanium avec une épaisseur inférieure à l'épaisseur critique. L'épaisseur critique est l'épaisseur sous laquelle la qualité cristalline de la couche épitaxiée est garantie : au dessus de cette épaisseur, des défauts, notamment des dislocations, apparaissent dans la couche épitaxiée. Sous cette épaisseur critique, la structure cristalline de la couche 4 de germanium (et en particulier le paramètre de maille) est imposée par la structure cristalline superficielle de la plaque 2 : le paramètre de maille de la couche 4 de germanium est égal à celui de la structure cristalline superficielle de la plaque 2 de silicium. L'épaisseur critique dépend bien évidemment du substrat sur lequel est réalisé l'épitaxie. Au sujet de l'épaisseur critique, on pourra se référer à l'article "Calculation of critical layer thickness considering thermal strain in Si1-x Gex/Si strained-layer hetero-structures", de J. Huang et al. in J. Appl. Phys. 83 (1), 1998 American Institute of Physics.

On fait croître dans l'exemple décrit ici pour une plaque massive de silicium une couche de germanium 4 avec une épaisseur inférieure à 3 nm. On obtient ainsi l'empilement représenté en figure 2.

Du fait que l'épaisseur de la couche de germanium 4 est inférieure à l'épaisseur critique et que sa structure cristalline est imposée par celle de la plaque 2, par ailleurs de bonne qualité cristalline, le taux de dislocations dans la couche de germanium est pratiquement nul.

Dans le mode de réalisation proposé ici, on dépose alors (par exemple également par épitaxie) une couche très fine 6 de silicium, avec une épaisseur inférieure à 1 nm, typiquement quelques angströms. On obtient alors la structure représentée à la figure 3.

En variante, il est possible d'épitaxier une couche un peu plus épaisse de silicium (typiquement, entre 1 nm et 20 nm, par exemple entre 2 nm et 3 nm) et d'oxyder tout ou partie de cette couche par traitement de surface chimique ou physique. Il pourra par exemple subsister après traitement quelques angströms de silicium, avantageusement 1 ou 2 monocouches de silicium.

Du fait de la qualité cristalline du silicium de la plaque 2 et du germanium épitaxié, la couche de silicium épitaxiée sur le germanium présentera elle aussi une bonne qualité cristalline et l'interface entre cette couche de silicium et la couche de germanium sera de bonne qualité, en particulier d'un point de vue électrique.

On peut remarquer que le paramètre de maille du germanium dans la couche étant déterminé par celui du silicium de la couche, celui-ci sera également repris dans la couche réalisée en silicium et qu'on évitera ainsi les dislocations quelle que soit l'épaisseur de celle-ci. On remarque que, dans cette structure, la couche de germanium 4 est encapsulée entre la plaque de silicium 2 et la couche fine 6, ce qui permet une bonne protection de la couche de germanium dans les étapes ultérieures du procédé décrites à présent.

Après un nettoyage adapté, on dépose sur la couche fine 6 un diélectrique par exemple Si₃N₄, un matériau à haute permittivité (comme AIN ou HfO₂), un oxyde (comme Al₂O₃ ou SiO₂). Dans cet exemple, on choisit de déposer du SiO₂, par exemple par un procédé du type PECVD (pour "*Plasma Enhanced Chemical Vapor Deposition*", c'est-à-dire dépôt chimique en phase vapeur assisté par plasma) ici à une température de l'ordre de 380° C, afin d'obtenir une épaisseur de 10 nm à 300 nm d'oxyde densifié ou non.

La couche d'oxyde 8 ainsi déposée est destinée à former la couche d'oxyde enterré (ou BOX de l'anglais "*Buried Oxide*") de la structure GeOI finalement obtenue.

L'empilement obtenu après dépôt de la couche d'oxyde 8, représenté schématiquement à la figure 4, est ensuite reporté sur un substrat receveur 10, par exemple une autre plaque de silicium oxydée ou non en surface. Ce report s'effectue ici par collage moléculaire de la couche d'oxyde 8 sur le substrat receveur 10, après activation des faces à coller (par exemple par activation chimique et/ou polissage mécanique et/ou chimique - "*CMP*", et/ou plasma).

On obtient alors la structure représentée à la figure 5 et qui comprend l'empilement suivant :
- le substrat receveur 10 ;
- la couche d'oxyde 8 ;
- la couche fine de silicium 6;
- la couche de germanium 4 (dont l'épaisseur est inférieure à l'épaisseur critique) ;
- la plaque de silicium 2.

On procède alors à l'élimination de la plaque 2, par exemple par une action mécanique (rodage et polissage) et/ou une gravure chimique du silicium sélective par rapport au germanium (par exemple avec du TMAH, c'est-à-dire de l'hydroxyde de tetraméthylammonium).

L'avantage de la variante précitée utilisant un substrat SOI plutôt que la plaque 2 massive de silicium comme substrat de départ, réside dans une plus grande facilité d'élimination. En effet, avec un substrat SOI, moins de précautions sont à prendre : le substrat de silicium est tout d'abord éliminé par action mécanique jusqu'à atteindre la couche d'oxyde enterrée. Celle-ci peut ensuite être enlevée par exemple par gravure chimique sélective par rapport au silicium. On élimine ensuite la couche mince de silicium par exemple par gravure chimique sélective par rapport au germanium.

Dans le cas de la variante proposée ci-dessus et prévoyant une zone fragile enterrée, on peut procéder à la fracture au niveau de cette zone fragile enterrée, par traitement thermique et/ou mécanique par exemple. La couche résiduelle du substrat de silicium qui demeure solidaire de la couche de germanium après fracture peut ensuite être éliminée sélectivement, par exemple par gravure chimique comme dans le cas précédent.

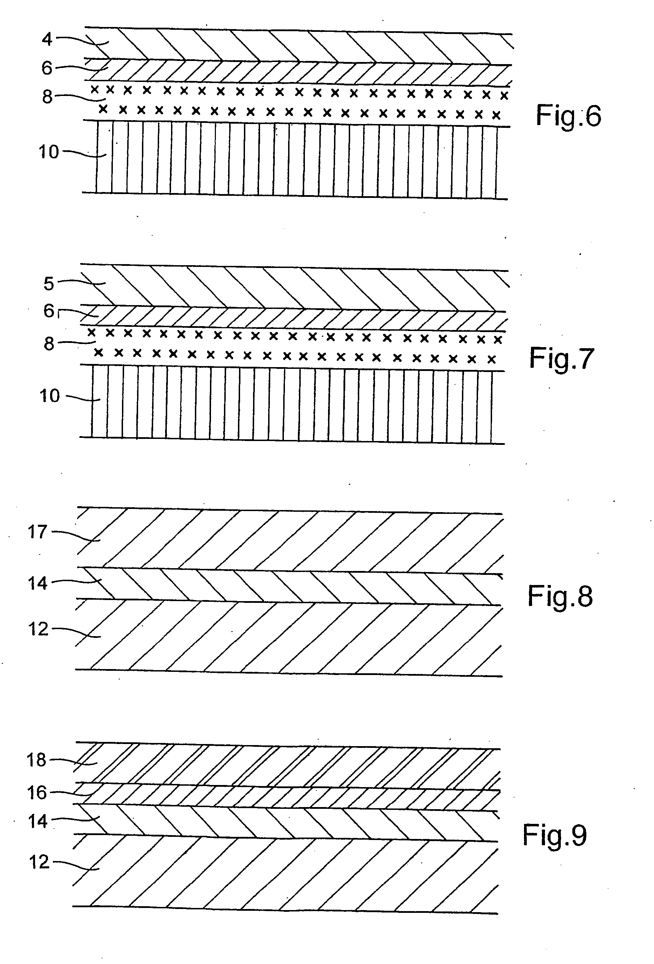

On obtient ainsi la structure GEOI souhaitée, comme représenté à la figure 6 :
- le substrat 10,
- la couche d'oxyde enterré 8,
- la couche fine de silicium 6,
- la couche de germanium 4, à présent superficielle.

Du fait de son épaisseur inférieure à l'épaisseur critique lors de sa croissance par épitaxie, la couche de germanium 4 inclura très peu de dislocations comme déjà mentionné. Les propriétés électriques de cette couche de germanium 4 sont donc conformes à celles attendues par l'utilisation du germanium, avec une qualité équivalente à celle qui aurait été obtenue par l'utilisation d'un substrat en germanium massif.

La présence d'une fine couche 6 de silicium typiquement inférieur au nanomètre entre la couche de germanium 4 et l'oxyde enterré 8 ne remet pas en cause ces bonnes propriétés électriques (elle les améliore même) et assure une interface de bonne qualité avec le germanium.

La structure GEOI peut ainsi être utilisée telle quelle dans un composant électronique.

Il est également possible, si on souhaite utiliser une structure GEOI avec une couche de germanium d'épaisseur supérieure, de procéder à une nouvelle croissance de germanium par épitaxie sur la couche de germanium 4 de la structure GeOI précédente. Pour préserver la qualité cristalline de la couche de germanium, il faudra s'assurer que l'épaisseur de germanium épitaxiée reste inférieure à l'épaisseur critique pour le nouveau substrat considéré à présent et formé de l'empilement Si/SiO₂/Si (facultatif) / Ge (contraint). Par ailleurs, si les contraintes au niveau de la qualité cristalline de la couche de germanium sont relâchées, une épaisseur plus grande pourra être épitaxiée.

Le taux de dislocations obtenu sera en tout cas inférieur au taux de dislocations que l'on aurait obtenu en faisant croître directement l'épaisseur totale de germanium finalement utilisée sur une plaque 2 de silicium massif.

On obtient dans ces hypothèses la structure représentée à la figure 7 qui diffère de celle de la figure 6 par l'épaisseur supérieure de la couche de germanium 5.

On va à présent décrire un second exemple de mise en oeuvre de l'invention en référence aux figures 8 et 9.

Ce second exemple est proche du premier exemple qui vient d'être décrit et on limitera pour l'essentiel sa description aux étapes qui le distinguent du premier exemple.

Dans ce second exemple, on utilise également une plaque de silicium 12 (ou en variante un substrat de type SOI) sur laquelle on a fait croître par épitaxie une couche de germanium 14 d'épaisseur inférieure à l'épaisseur critique, comme cela a été décrit en référence à la figure 2.

Selon le second mode de réalisation décrit ici, on fait croître par épitaxie sur la couche de germanium 4 une couche de silicium avec une épaisseur de l'ordre de quelques nanomètres, par exemple 5 nm (et de manière générale moins de 10 nm).

On obtient ainsi une structure avec une couche superficielle de silicium 17 ayant une épaisseur relativement grande par rapport à celle de la couche fine 6 du premier mode de réalisation.

On procède alors à l'oxydation de tout ou partie de la couche superficielle de silicium 17, par exemple par traitement plasma ou chimique, ou par oxydation thermique (naturellement, à des températures qui ne risquent pas de détériorer la couche de germanium 14 sous-jacente) afin d'obtenir en surface une couche d'oxyde thermique 18 destinée à former l'oxyde enterré dans la structure GEOI finale, comme représenté à la figure 9.

Comme visible sur cette figure, on propose ici avantageusement d'arrêter l'oxydation quelques angströms avant l'interface entre la couche de germanium 14 et la couche de silicium 17 afin de laisser subsister une couche fine de silicium 16 entre la couche de germanium 14 et la couche d'oxyde 18 pour des raisons électriques (les interfaces SiO₂/Si/Ge étant de meilleure qualité que l'interface Ge/SiO₂ comme déjà indiqué).

La structure ainsi obtenue et représentée à la figure 9 est tout à fait comparable à celle obtenue et représentée en figure 4 dans le premier mode de réalisation et pourra ainsi être utilisée de manière identique à cette dernière (conformément aux étapes décrites plus haut et représentées aux figures 5 et 6, et éventuellement 7) pour former une structure GeOI.

La couche de germanium 14 ayant une épaisseur inférieure à l'épaisseur critique comme dans le premier mode de réalisation, les avantages procurés ici sont identiques à ceux déjà décrits.

En outre, cette solution permet d'obtenir un oxyde enterré (issu de la couche d'oxyde thermique 18) de meilleure qualité que lorsque cet oxyde est obtenu par dépôt (premier mode de réalisation ci-dessus) et une meilleure interface entre cet oxyde et la couche fine de silicium (16). Il est néanmoins possible si on souhaite une couche d'oxyde plus épaisse, de déposer sur la couche d'oxyde thermique, une couche complémentaire d'oxyde.

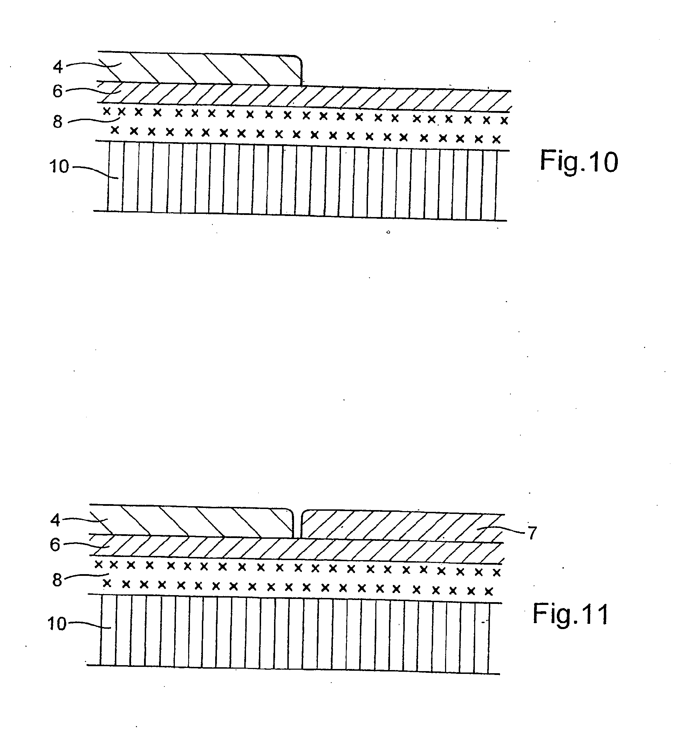

A partir des structures obtenues aux figures 6 ou 7, c'est-à-dire de structures GEOI présentant sous la couche mince de germanium une très fine couche de silicium (de bonne qualité cristalline), il est possible de graver localement le germanium comme représenté à la figure 10 pour mettre à nu localement la fine couche de silicium 6, 16, puis venir faire une reprise d'épitaxie locale et sélective de silicium sur la couche fine de silicium 6, 16 afin d'obtenir une nouvelle couche de silicium 7 dans la région précédemment gravée dans la couche de germanium 4, comme représenté à la figure 11. On pourra par exemple prévoir, après gravure de la couche de germanium et avant la reprise d'épitaxie de silicium, de protéger les îlots de germanium encore présent par une couche locale de protection laissant subsister des ouvertures de silicium.

Cette couche pourra être sélectivement éliminée après l'épitaxie de silicium.

Grâce à la structure de la figure 11, il est possible d'utiliser chacune des régions (parties résiduelles de la couche 4 et couche issue de la reprise sélective 7) en bénéficiant des propriétés de chacun des deux matériaux, par exemple pour former des composants différents.

L'invention n'est pas limitée aux modes de réalisation qui viennent d'être décrits.

Par exemple, si les modes de réalisation présentés ci-dessus proposent de déposer la couche de germanium sur du silicium relaxé (Si massif ou SOI), il est également possible de faire croître le germanium sur du silicium contraint (obtenu par exemple par épitaxie sur du SiGe ou provenant d'une structure de type silicium contraint sur isolant, ou sSOI), ce qui a pour avantage d'augmenter l'épaisseur critique du germanium déposé par épitaxie (c'est-à-dire l'épaisseur possible de germanium qui peut être déposée par épitaxie tout en conservant le paramètre de maille de la structure cristalline qui le reçoit, en minimisant ainsi les risques de dislocations).

On peut également faire croître le germanium sur un substrat présentant au moins en surface une couche de SiₓGe₁₋ₓ, par exemple SiGeOI, avec par exemple x=0,8, soit 20 % de germanium.

Cette solution permet également d'augmenter l'épaisseur de germanium que l'on peut déposer sans dégradation de qualité cristalline.

Pour ces deux derniers exemples (Si contraint et SiGe), si une couche de silicium est épitaxiée sur la couche de germanium épitaxiée, on veillera à ce que l'épaisseur de cette couche de silicium (formée dans ce cas dans un matériau de paramètre de maille différent de celui de la couche superficielle du substrat) reste inférieure à l'épaisseur critique épitaxiable compte tenu de la structure sur laquelle cette épitaxie est réalisée, et ce afin de préserver la qualité cristalline de cette couche et de la couche de germanium sous-jacente.

## Revendications

1. Procédé de fabrication d'un élément en couches minces connu sous l'acronyme GEOI (Germanium On Insulator) comprenant les étapes suivantes :
- croissance par épitaxie d'une couche cristalline (4 ; 14) d'un premier matériau sur une couche cristalline (2 ; 12) d'un support (2 ; 12) formée dans un second matériau différent du premier matériau, le premier matériau étant du germanium, ladite couche du premier matériau (4 ; 14) ayant une épaisseur inférieure à l'épaisseur critique, l'épaisseur critique étant l'épaisseur en deçà de laquelle le premier matériau croît selon la structure cristalline de la couche cristalline du support ;
- formation d'une couche de diélectrique (8 ; 18) du côté de la face de ladite couche du premier matériau (4 ; 14) opposée au support (2 ; 12) pour former une structure donneuse (2, 4, 8 ; 12, 14, 18) ;
- assemblage de la structure donneuse (2, 4, 8 ; 12, 14, 18) avec un substrat de réception (10) ;
- élimination du support (2 ; 12),
où le procédé comprend, préalablement à la formation de la
couche de diélectrique (8 ; 18), une étape de croissance par épitaxie d'une couche de troisième matériau (6 ; 17) sur ladite couche du premier matériau (4 ; 14), le matériau et l'épaisseur de la couche de troisième matériau étant choisis de sorte que le paramètre de maille du troisième matériau soit déterminé par celui de la couche cristalline du support (2 ; 12), le troisième matériau étant du silicium et la couche du troisième matériau présentant une épaisseur inférieure à 1nm après la formation de la couche de diélectrique.

2. Procédé selon la revendication 1, comprenant les étapes suivantes postérieures à l'étape d'élimination du support :
- gravure locale de la couche cristalline du premier matériau jusqu'à la couche du troisième matériau ;
- croissance par épitaxie du troisième matériau sur les régions de la couche du troisième matériau mises à nu par la gravure.

3. Procédé selon la revendication 1 ou 2, où l'étape de formation de la couche de diélectrique comprend une étape d'oxydation au moins partielle de la couche épitaxiée du troisième matériau (17) afin d'obtenir ladite couche de diélectrique (18).

4. Procédé selon l'une des revendications 1 à 3, où ladite étape de formation de la couche de diélectrique (8 ; 18) de la structure comprend une étape de dépôt d'une couche de diélectrique (8). ,

5. Procédé selon l'une des revendications 1 à 4, où la couche de diélectrique (8 ; 18) est une couche d'oxyde.

6. Procédé selon les revendications 1 à 5, où le support est une plaque du second matériau (2).

7. Procédé selon l'une des revendications 1 à 5, où le support est du type couche superficielle sur isolant dont la couche superficielle (26) forme la couche cristalline du second matériau.

8. Procédé selon l'une des revendications 1 à 7, où le second matériau est du silicium relaxé.

9. Procédé selon l'une des revendications 1 à 7, où le second matériau est du silicium contraint.

10. Procédé selon l'unes des revendications 1 à 7, où le second matériau est du SiGe.

11. Procédé selon l'une des revendications 1 à 10, comprenant une étape de croissance par épitaxie du premier matériau sur la face de la couche cristalline (4 ; 14) du premier matériau laissée libre par l'élimination du support (2 ; 12).

## Patentansprüche

1. Verfahren zur Herstellung eines Dünnschichtelements, das unter dem Akronym GeOI (Germanium On Insulator) bekannt ist, welches die folgenden Schritte enthält:
- epitaxiales Wachstum einer kristallinen Schicht (4; 14) eines ersten Materials auf einer kristallinen Schicht (2; 12) eines Trägers (2; 12), die aus einem zweiten Material geformt ist, das sich vom ersten Material unterscheidet, wobei das erste Material Germanium ist, wobei die Schicht des ersten Materials (4; 14) eine geringere Dicke als die kritische Dicke hat, wobei die kritische Dicke die Dicke ist, unterhalb der das erste Material gemäß der kristallinen Struktur der kristallinen Schicht des Trägers wächst;
- Formen einer Dielektrikumschicht (8; 18) auf der Seite der zum Träger (2; 12) entgegengesetzten Seite der Schicht des ersten Materials (4; 14), um eine Geberstruktur (2, 4, 8; 12, 14, 18) zu formen;
- Zusammenfügen der Geberstruktur (2, 4, 8; 12, 14, 18) mit einem Aufnahmesubstrat (10);
- Entfernen des Trägers (2; 12),
wobei das Verfahren vor dem Formen der Dielektrikumschicht (8; 18) einen Schritt des epitaxialen Wachsens einer Schicht eines dritten Materials (6; 17) auf der Schicht des ersten Materials (4; 14) enthält, wobei das Material und die Dicke der Schicht eines dritten Materials so gewählt werden, dass der Maschenparameter des dritten Materials durch denjenigen der kristallinen Schicht des Trägers (2; 12) bestimmt wird, wobei das dritte Material Silicium ist und die Schicht des dritten Materials nach dem Formen der Dielektrikumschicht eine Dicke von weniger als 1nm aufweist.

2. Verfahren nach Anspruch 1, das nach dem Schritt des Entfernens des Trägers die folgenden Schritte enthält:
- lokales Ätzen der kristallinen Schicht des ersten Materials bis zur Schicht des dritten Materials;
- epitaxiales Wachsen des dritten Materials auf den Bereichen der Schicht des dritten Materials, die durch das Ätzen freigelegt wurden.

3. Verfahren nach Anspruch 1 oder 2, wobei der Schritt des Formens der Dielektrikumschicht einen Schritt der mindestens teilweisen Oxidation der epitaxierten Schicht des dritten Materials (17) enthält, um die Dielektrikumschicht (18) zu erhalten.

4. Verfahren nach einem der Ansprüche 1 bis 3, wobei der Schritt des Formens der Dielektrikumschicht (8; 18) der Struktur einen Schritt der Abscheidung einer Dielektrikumschicht (8) enthält.

5. Verfahren nach einem der Ansprüche 1 bis 4, wobei die Dielektrikumschicht (8; 18) eine Oxidschicht ist.

6. Verfahren nach einem der Ansprüche 1 bis 5, wobei der Träger eine Platte des zweiten Materials (2) ist.

7. Verfahren nach einem der Ansprüche 1 bis 5, wobei der Träger von der Art Oberflächenschicht auf einem Isolator ist, dessen Oberflächenschicht (26) die kristalline Schicht des zweiten Materials formt.

8. Verfahren nach einem der Ansprüche 1 bis 7, wobei das zweite Material relaxiertes Silicium ist.

9. Verfahren nach einem der Ansprüche 1 bis 7, wobei das zweite Material verspanntes Silicium ist.

10. Verfahren nach einem der Ansprüche 1 bis 7, wobei das zweite Material SiGe ist.

11. Verfahren nach einem der Ansprüche 1 bis 10, das einen Schritt des epitaxialen Wachsens des ersten Materials auf der Seite der kristallinen Schicht (4; 14) des ersten Materials enthält, die durch das Entfernen des Trägers (2; 12) frei gelassen wird.

## Claims

1. Method for making a thin-film element known under the acronym GeOI (Germanium On Insulator), comprising the following steps:
- epitaxial growth of a crystalline layer (4; 14) of a first material on a crystalline layer (2; 12) of a support (2; 12) formed in a second material different from the first material, the first material being germanium, said layer (4; 14) of the first material having a thickness less than the critical thickness, the critical thickness being the thickness below which the first material grows depending on the crystalline structure of the crystalline layer of the support;
- formation of a dielectric layer (8; 18) on the side of said layer (4; 14) of the first material opposite the support (2; 12) to form a donor structure (2, 4, 8; 12, 14, 18);
- assembly of the donor structure (2, 4, 8; 12, 14, 18) with a receiver wafer (10);
- elimination of the support (2; 12),
wherein the method comprises, prior to the formation of the dielectric layer (8; 18), a step of epitaxial growth of a third material layer (6; 17) on said first material layer (4; 14), the material and the thickness of the third material layer being chosen so that the lattice parameter of the third material is determined by that of the crystalline layer of the support (2; 12), the third material being silicon and the third material layer having a thickness of less than 1 nm after the formation of the dielectric layer.

2. Method according to Claim 1, comprising the following steps after the step of elimination of the support:
- local etching of the crystalline layer of the first material as far as the third material layer;
- epitaxial growth of the third material on the regions of the third material layer exposed by the etching.

3. Method according to Claim 1 or 2, wherein the step of formation of the dielectric layer comprises a step of at least partial oxidation of the epitaxially grown third material layer (17) in order to obtain said dielectric layer (18).

4. Method according to any one of Claims 1 to 3, wherein said step of formation of the dielectric layer (8, 18) of the structure comprises a step of depositing a dielectric layer (8).

5. Method according to any one of Claims 1 to 4, wherein the dielectric layer (8; 18) is an oxide layer.

6. Method according to Claims 1 to 5, wherein the support is a plate (2) of the second material.

7. Method according to any one of Claims 1 to 5, wherein the support is of the superficial layer on insulator type, the superficial layer (26) whereof forms the crystalline layer of the second material.

8. Method according to any one of Claims 1 to 7, wherein the second material is relaxed silicon.

9. Method according to any one of Claims 1 to 7, wherein the second material is strained silicon.

10. Method according to any one of Claims 1 to 7, wherein a second material is SiGe.

11. Method according to any one of Claims 1 to 10, comprising a step of epitaxial growth of the first material on the face of the crystalline layer (4; 14) of the first material left free by the elimination of the support (2; 12).
